(19) Europäisches Patentamt / European Patent Office / Office européen des brevets

(11) **EP 2 512 043 B1**

(12) **EUROPEAN PATENT SPECIFICATION**

(45) Date of publication and mention
of the grant of the patent:
**22.01.2014 Bulletin 2014/04**

(51) Int Cl.:
*H04B 10/2569* (2013.01)     *H04B 10/50* (2013.01)
*H01S 5/14* (2006.01)     *H01S 3/106* (2006.01)

(21) Application number: **11162510.9**

(22) Date of filing: **14.04.2011**

(54) **Polarization stabilization scheme for un-cooled self-tuning cavity for colorless ultra broadband PON**

Polarisierungsstabilisierungsschema für ungekühlten, selbstjustierenden Hohlraum für farblose Ultrabreitband-PON

Schéma de stabilisation de polarisation pour cavité auto-réglable sans refroidissement pour PON à ultra large bande incolore

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**17.10.2012 Bulletin 2012/42**

(73) Proprietor: **Alcatel Lucent**
**75007 Paris (FR)**

(72) Inventors:
• **Martinelli, Mario**
  **20097 San Donato Milanese (IT)**
• **Gavioli, Giancarlo**
  **Arcore (IT)**
• **Galli, Paola**
  **25030 Adro (IT)**
• **Di Mola, Domenico**
  **20045 Besana Brianza (IT)**
• **Parolari, Paola**
  **20052 Monza (IT)**
• **Marazzi, Lucia**
  **27010 Borgarello (IT)**
• **Razzetti, Luca**
  **20099 Sesto San Giovanni (IT)**
• **Campi, Domenico**
  **10052 Bardonecchia (IT)**
• **Suberini, Luca**
  **20131 Milano (IT)**

(74) Representative: **Wetzel, Emmanuelle**
**Alcatel Lucent**
**Intellectual Property & Standards**
**70430 Stuttgart (DE)**

(56) References cited:
**WO-A1-2009/007973     WO-A1-2011/018054**

• CHO K Y ET AL: "Long-Reach Coherent WDM PON Employing Self-Polarization-Stabilization Technique", JOURNAL OF LIGHTWAVE TECHNOLOGY, IEEE SERVICE CENTER, NEW YORK, NY, US, vol. 29, no. 4, 1 February 2011 (2011-02-01), pages 456-462, XP011329360, ISSN: 0733-8724, DOI: 10.1109/JLT.2010.2096800

**Description**

**Field of the invention**

The present document relates to the field of optical access networks. In particular, the present document relates to an optical transmitter, in particular (but not exclusively) for a WDM (Wavelength Division Multiplexing) passive optical network, and to a WDM PON comprising such an optical transmitter.

**Background**

A passive optical network (briefly termed PON) is a type of access network, i.e. a network allowing a plurality of users to be connected to a node of a core network (e.g., a metropolitan area network). A PON typically comprises an optical line termination (OLT) and an optical distribution network (ODN). The ODN in turn comprises a plurality of optical links (typically comprising silica-based single-mode optical fibers) and further passive optical components arranged so as to form a point-multipoint structure whose root is connected to the OLT. The OLT is typically located at a central office (CO) of the service provider. Each optical link of the OLT may be terminated at its far end by a respective optical network unit (ONU). Depending on the applications, an ONU may be located within the user's home (FTTH - Fiber To The Home), at the basement of a building (FTTB - Fiber To The Building) or at the curb in the proximity of one or more buildings (FTTC - Fiber To The Curb).

In a WDM PON, each ONU may communicate with the OLT by using a respective pair of wavelengths, comprising an upstream wavelength (which the ONU uses for transmission to the OLT) and a downstream wavelength (which the OLT uses for transmission to the ONU). The upstream wavelengths may be for instance located in the so-called C band (1530 nm - 1565 nm), whereas the downstream wavelengths may be for instance located in the so-called L band (>1565 nm).

In a WDM PON, the ODN typically comprises a so-called "remote node", a feeder optical fiber (feeder fiber) connecting the remote node to the OLT and a number of distribution optical fibers (distribution fibers) radiating from the remote node. Each distribution fiber may be terminated at its far end by an ONU or by a power splitter connecting the distribution fiber with multiple ONUs via multiple drop optical fibers (drop fibers). The feeder fiber has a length typically ranging from about 5 km to about 40 km. The distribution fibers typically have a length ranging from some tens of meters to a few kilometers, depending on the environment (metropolitan or rural) and on the application (FTTH, FTTB or FTTC). The remote node is typically a passive node, i.e. it comprises only passive components (typically arrayed waveguide gratings, couplers, etc.) that do not need a power supply.

In the downstream direction, the OLT generates downstream optical signals (downstream signals) at the downstream wavelengths associated to the ONUs, multiplexes them according to the known WDM technique and transmits them to the remote node along the feeder fiber. At the remote node, the downstream signals are demultiplexed and each of them is forwarded to a respective ONU along a respective distribution fiber.

In the upstream direction, each ONU generates a respective upstream signal at the upstream wavelength associated thereto and transmits it along the respective distribution fiber to the remote node. The remote node multiplexes all the upstream signals received from the various ONUs according to the known WDM technique, and forwards them to the OLT through the feeder fiber. At the OLT, the upstream signals are demultiplexed and subjected to subsequent processing. Hence, each ONU should comprise a transmitter capable of transmitting at the upstream wavelength assigned thereto. To minimize both manufacturing and inventory costs of the ONUs, it is desirable to provide all the ONUs with a same type of transmitter which is "colorless", i.e. which in principle may transmit optical signals over a wide range of wavelengths, and that may be optically tuned by the WDM PON itself on the proper upstream wavelength assigned to the ONU, when the ONU is connected to the far end of a distribution fiber.

In the present document it is proposed to implement colorless ONU's by using self-tuning direct modulated lasers (STML), where self-tuning indicates that the laser is configured to tune on a set of wavelengths which depends on wavelength selection means, e.g. an Array Waveguide Grating (AWG), within the remote node. Furthermore, the STML hosts a gain and modulation unit (GMU) to enable lasing and data modulation. In such STMLs, the laser cavity is defined by two reflective means, e.g. two mirrors; a rear mirror which may be positioned next to the gain medium (at the ONU) and a remote mirror, which may be positioned next to the wavelength selection means (at the remote node). As indicated above, the ONU and the remote node are linked by the distribution fiber. As such, the remote mirror may be linked to the GMU by the distribution fiber which has a length of up to several kilometers.

The laser cavity may include active components such as the GMU, as well as passive components such as the AWG, the distribution fiber, optical couplers for signal tapping and power monitors, splices and fiber pigtails. The group of all passive components in the laser cavity may be referred to as the Embody Devices (ED).

In order to achieve a cost-competitive ONU solution which allows for an integration in small font-factor units, such as XFPs (10G small form factor pluggable) or SFPs (small form factor pluggable), while granting long-reach and high frequency operation, it is desirable to maximize the gain, output power and/or modulation bandwidth of the GMU, while minimizing the chirp factor and while operating in an un-cooled mode. By way of example, in case of semiconductor based GMUs the above mentioned target parameters are usually coupled in trade-offs which may be controlled by engineering the GMU's physical structure. The engineering of the GMU with respect to the above mentioned target parameters can usually benefit when allowing a polarization sensitive operation of the GMU. An example are semiconductor devices based on Multi-Quantum Well (MQW) structures, which have demonstrated high output power, gain and modulation bandwidth under un-cooled operation, however at the cost of a relatively high polarization dependent gain (PDG).

The present document addresses the above mentioned technical problem of providing colorless, cost effective ONUs. It is proposed to make use of STMLs using un-cooled GMUs with high output power, gain and modulation bandwidth. In this context, means are described for making the STML operation independent of the effects caused by birefringence of the ED. As a result of providing a polarization independent laser cavity, polarization sensitive GMU with an arbitrary PDG can be used, i.e. to achieve high output power, gain and modulation bandwidth and potentially enable un-cooled operation of the GMUs.

WO2011/018054 describes a WDM transmitter comprising a polarization rotator and a polarization rotator mirror. WO2009/007973 describes a PON making use of a polarization rotator and a polarization rotator mirror.

According to an aspect, an optical transmitter arrangement, e.g. for a WDM PON, is described. The arrangement may comprise a first mirror (also referred to as the rear mirror) and a second mirror (also referred to as the remote mirror) at a first end and a second end of a cavity, respectively. The first and second mirror may form the ends of a laser cavity generating an optical radiation propagating back and forth in the cavity.

For this purpose, the arrangement may comprise an optical amplifier configured to (also) amplify light propagating within the cavity. The optical amplifier may be positioned within the cavity upstream of the first mirror. The optical amplifier may be configured to generate and/or amplify light having a first polarization, i.e. light which is polarized within a first polarization plane. In particular, the optical amplifier may be a polarization dependent amplifier, meaning that the gain and/or the output power of the optical amplifier may be dependent on the polarization of the input light. As such, the optical amplifier may be configured to provide a maximum gain and/or output power for light which is polarized within the first polarization plane. In other words, the amplifier may exhibit a particularly strong amplification gain for light in the first polarization plane. Furthermore, the optical amplifier may be a colorless optical amplifier, i.e. an optical amplifier generating light in a wide optical spectrum.

It should be noted that the term "upstream" is used in line with the definition used in WDM PON networks, wherein the propagation direction of light traveling from the OLT to the ONU is referred to as downstream direction, and wherein the propagation direction of light traveling from the ONU to the OLT is referred to as upstream direction.

The optical transmitter arrangement may comprise an optical waveguide configured to transmit light from the optical amplifier to the second mirror and vice versa. The optical waveguide may exhibit birefringence and variation of the principal axis of polarization. As such, the optical waveguide may affect or change the polarization of the light as the light is transmitted from the optical amplifier towards the second mirror (and vice versa). The optical waveguide may be a single-mode fiber, e.g. the distribution fiber of a PON connecting the remote node with an ONU.

The optical transmitter arrangement may comprise a first non-reciprocal polarization rotator or Faraday Rotator (FR), e.g. with $\pm 45$ degree of rotation power (wherein the term "$\pm$" refers to "plus" or "minus"), positioned within the cavity upstream of the optical amplifier and downstream of the optical waveguide. In other words, the first non-reciprocal polarization rotator (or FR) may be positioned between the optical amplifier and the optical waveguide. The first non-reciprocal polarization rotator (or FR) may be configured to rotate the polarization of the light. As such, the polarization of light entering the rotator may be changed at the output with respect to the input of the rotator. The first non-reciprocal polarization rotator (or FR) may be configured to rotate light in the upstream direction and to rotate light in the downstream direction, such that the overall rotation (i.e. the sum of the rotation in both propagation directions) is substantially $\pm 90$ degrees. In particular, the first non-reciprocal polarization rotator (or FR) may be configured to rotate the polarization of the light by substantially $\pm 45$ degrees (plus or minus a multiple of 180 degrees).

The optical transmitter arrangement may comprise a second non-reciprocal polarization rotator (or FR) with $\pm 45$ degree of rotation power positioned within the cavity upstream of the optical waveguide and downstream of the second mirror. In other words, the second non-reciprocal polarization rotator (or FR) may be positioned between the optical waveguide and the second mirror (also referred to as the remote mirror). The second non-reciprocal polarization rotator (or FR) may be positioned between the optical waveguide and immediately before of the second mirror in order to make a so-called Faraday Rotator Mirror (FRM).

Overall, the first and second non-reciprocal polarization rotators (or FR) may be configured to rotate the polarization of the light such that light which re-enters the optical amplifier after having been reflected by the second mirror is essentially aligned with the first polarization plane, i.e. the light is polarized such that the SOP of the light corresponds to the characteristics of the polarization dependent gain of the amplifier. In other words the polarization state of the returned light is within predetermined boundaries corresponding to the polarization dependent characteristics of the amplifier. As outlined above, this may be achieved by ensuring that the first non-reciprocal polarization rotator (or FR) performs a rotation of the light in the upstream direction and of the light in the retracing downstream direction by substantially ±45 degrees (plus or minus a multiple of 180 degrees), respectively. Furthermore, this may be achieved by ensuring that the second non-reciprocal polarization rotator (or FR) performs a rotation of the light in the upstream direction and of the light in the retracing downstream direction by substantially ±45 degrees (plus or minus a multiple of 180 degrees), respectively. Overall, the appropriate polarization of the re-entering light may be achieved by ensuring that the total polarization rotation of the light having made a round-trip (e.g. a single round-trip) through the cavity has incurred a total polarization rotation of substantially 0 or 360 degrees, or a multiple thereof.

The optical transmitter arrangement may comprise a wavelength selection unit within the cavity upstream of the optical waveguide and downstream of the second non-reciprocal polarization rotator (or FR). In particular, the wavelength selection unit may be positioned within the remote node of a WDM PON. The wavelength selection unit may be configured to filter out light at a first wavelength from the light coming from the optical amplifier. For filtering light at the first wavelength, the wavelength selection unit may comprise an optical multiplexer / demultiplexer, e.g. an arrayed waveguide grating, a thin film filter, a diffraction grating and/or an echelle grating.

A fraction of the filtered light at the first wavelength may be coupled to the second mirror through a reflection port of the wavelength selection unit. For this purpose the wavelength selection unit may comprise a power splitter or coupler. As such, the wavelength selection unit may isolate light at the first wavelength from the (colorless) light generated by the optical amplifier. As such, it may be ensured that only light at the first wavelength is fed back to the optical amplifier. By doing this, an optical radiation at the first wavelength propagating back and forth in the cavity may be generated.

The wavelength selection unit may also be configured to direct a further fraction of the filtered light at the first wavelength to an output port of the wavelength selection unit. By doing this, an optical signal at the first wavelength may be provided at the output port of the wavelength selection unit. This output port may be connected to a feeder fiber which transmits the optical signal on the upstream towards an OLT of the PON.

As indicated above, the wavelength selection unit may be part of the remote node of a PON. In particular, the second non-reciprocal polarization rotator (or FR), the second mirror and/or the wavelength selection unit may be comprised with the remote unit which may be optically connected to the optical amplifier via the optical waveguide (e.g. the distribution fiber).

In other words, a remote node configured to provide an optical uplink signal at the first wavelength is described. The remote node may comprise a wavelength selection unit as described in the present document. The wavelength selection unit may comprise an optical multiplexer / demultiplexer (e.g. an AWG) configured to isolate an optical signal at the first wavelength from an optical signal comprising a plurality of wavelengths. Furthermore, the remote node may comprise an optical power splitter configured to extract at least two fractions of the optical signal at the first wavelength. A first fraction of the optical signal may be directed to a non-reciprocal polarization rotator (or FR), which may be configured as the second non-reciprocal polarization rotator (or FR) outlined above, and to a subsequent mirror which may be configured as the second mirror or rear mirror outlined in the present document. The two components together (i.e. mirror and FR) can form a Faraday Rotator Mirror (FRM) which may provide the functionality of the FR and the mirror in a joint component. A second fraction of the optical signal may be directed to an uplink port of the remote node, thereby yielding the optical uplink signal. The uplink port may be configured to connect to a feeder fiber which leads to an OLT. Furthermore, the remote node may comprise a downlink port configured to connect e.g. a distribution fiber. Typically, the remote node comprises a plurality of downlink ports. The remote node may be configured to receive the optical signal comprising a plurality of wavelengths via the downlink port. The optical signal comprising a plurality of wavelengths may be received e.g. from an ONU connected to the distribution fiber.

The optical transmitter arrangement may comprise a polarizer upstream of the optical amplifier and downstream of the first non-reciprocal polarization rotator (or FR). In other words, the optical transmitter arrangement may comprise a polarization filter. Such polarizer or polarization filters may be configured to only let pass light in a pre-determined polarization plane. In particular, the polarizer may be configured to ensure that only light which has a polarization in the first polarization plane is transmitted from the optical amplifier. Optical amplifiers (e.g. the gain and modulation unit) may generate light at different polarizations, i.e. at polarizations different from the first polarization plane (e.g. as a result of spontaneous emission). This may be particularly the case of polarization independent optical amplifiers. By using a polarizer, such light at different polarizations may be prevented from travelling through the cavity.

The optical transmitter arrangement may comprise a modulator configured to modulate the optical radiation at the first wavelength. For this purpose, the modulator is typically positioned within the cavity. By way of example, the optical amplifier and the modulator may be implemented using a semiconductor optical amplifier, e.g. using a Multi-Quantum Well semiconductor optical amplifier. The optical amplifier may alternatively be implemented using bulk amplifiers. It should be noted that the first non-reciprocal polarization rotator (or FR), the optical amplifier, the first mirror and/or the modulator may be integrated within a small form factor pluggable unit (e.g. an XFP or an SFP).

According to a further aspect an optical component, e.g. for a WDM PON, is described. In particular, the optical component may be part of an ONU of a WDM PON. The optical component may be configured to generate a modulated optical signal. For this purpose, the optical component may comprise a semiconductor optical amplifier configured to generate modulated light at a first polarization. Furthermore, the optical component may comprise a reflective section, at a rear side (i.e. in the downstream direction) of the component. The reflective section, e.g. a mirror, may be configured to reflect the modulated light. In an embodiment, the optical component may comprise a polarizer at a front side of the optical component, notably at a front side of the optical amplifier. In particular, the polarizer may be directly adjacent to the optical amplifier or adjacent to the FR.

In addition, the optical component may comprise a non-reciprocal polarization rotator (or FR), at a front side (i.e. towards the upstream direction) of the component. The non-reciprocal polarization rotator (or FR) may be configured as the first non-reciprocal polarization rotator (or FR) outlined above. In particular, the non-reciprocal polarization rotator (or FR) may be configured to rotate the polarization of the modulated light, thereby yielding the modulated optical signal. Furthermore, the optical component may comprise an output port, at the front side of the component, configured to provide the modulated optical signal to an optical waveguide external to the component, e.g. a distribution fiber of the PON. The optical component may be integrated within a small form factor pluggable unit (e.g. an XFP or an SFP).

According to another aspect, a wavelength division multiplexing passive optical network (WDM PON) is described. The WDM PON may comprise an optical network unit (ONU) configured to transmit an optical uplink signal. Typically, the WDM PON comprises a plurality of ONUs configured to transmit a plurality of optical uplink signals, respectively. The plurality of optical uplink signals may have different wavelengths. Furthermore, the WDM PON may comprise a remote node configured to multiplex the optical uplink signal (or the plurality of optical uplink signals) onto a feeder fiber. The feeder fiber may connect the remote node to an optical line termination (OLT), positioned e.g. at a CO of the network. The optical line termination may be configured to receive the optical uplink signal (or the plurality of optical uplink signals). The optical network unit and the remote node of the WDM PON may comprise an optical transmitter arrangement having any of the features outlined in the present document.

According to a further aspect, a method for generating an optical signal within a cavity comprising a first and second mirror is described. The method may comprise generating and/or amplifying an optical signal being polarized within a first polarization plane. This may be achieved by using an optical amplifier (e.g. a colorless optical amplifier as described in the present document). The method may comprise reflecting the optical signal at a rear side of the optical amplifier (i.e. downstream of the optical amplifier) using the first mirror. At the front side of the optical amplifier, i.e. in the upstream direction of the optical amplifier), the polarization (i.e. the plane of polarization) of the optical signal on the upstream propagation may be rotated by an initial rotation. By way of example, the initial rotation may be substantially ±45 degrees (plus or minus a multiple of 180 degrees). The initial rotation may be performed by a first non-reciprocal polarization rotator (or FR), as outlined above. Prior to the initial rotation, the optical signal may be polarized at the output of the optical amplifier in order to ensure that the optical signal is only polarized within the first polarization plane.

Subsequent to rotating, the optical signal may be transmitted via an optical waveguide to the second mirror. The method may comprise, subsequent to transmitting, rotating the polarization of the optical signal by substantially ±45 degrees (plus or minus a multiple of 180 degrees) at the second mirror prior to reflection by the second mirror. The rotation may be performed by a second non-reciprocal polarization rotator (or FR), as outlined above. Subsequently, the optical signal is reflected by the second mirror.

On the downstream propagation towards the optical amplifier, the method may proceed in rotating the polarization of the optical signal by substantially ±45 degrees (plus or minus a multiple of 180 degrees) at the second mirror. The rotation may be performed by a second non-reciprocal polarization rotator (or FR), as outlined above. Subsequent to rotating, the optical signal may be transmitted via the optical waveguide to the optical amplifier. Furthermore, the method may comprise rotating the polarization of the optical signal by a final rotation prior to entering the optical amplifier. By way of example, the final rotation may be substantially ±45 degrees (plus or minus a multiple of 180 degrees). The initial rotation may be performed by a first non-reciprocal polarization rotator (or FR), as outlined above. The initial and the final rotation may be selected such that the optical signal which re-enters the optical amplifier has a polarization within the first polarization plane.

It should be noted that the methods and systems including its preferred embodiments as outlined in the present document may be used stand-alone or in combination with the other methods and systems disclosed in this document. Furthermore, all aspects of the methods and systems outlined in the present patent application may be arbitrarily combined. In particular, the features of the claims may be combined with one another in an arbitrary manner.

## Brief description of the Figures

The invention is explained below in an exemplary manner with reference to the accompanying drawings, wherein

Fig. 1 shows an example WDM PON;
Figs. 2a and 2b show an example portion of a WDM PON and the upstream and downstream wavelengths assigned to its ONUs, respectively;

Fig. 3a illustrates a further representation of an example portion of a WDM PON;

Figs. 3b and 3c illustrate an example representation of the WDM PON of Fig. 3a using polarization operators;

Figs. 4a, 4b, and 4c illustrate an example portion of a WDM PON comprising Faraday rotators and the representation of the WDM PON using polarization operators;

Figs. 5a, 5b, and 5c illustrate another example portion of a WDM PON comprising Faraday rotators and the representation of the WDM PON using polarization operators;

Figs 6a and 6b show example states of polarization of light at the cavity output which is related to the state of polarization of light entering the gain and modulation unit;

Figs. 7a and 7b show example experimental setups for determining the states of polarization of Figs. 6a and 6b; and

Fig. 8 illustrates a further example portion of a WDM PON comprising Faraday rotators and a polarizer.

## Description of Embodiments

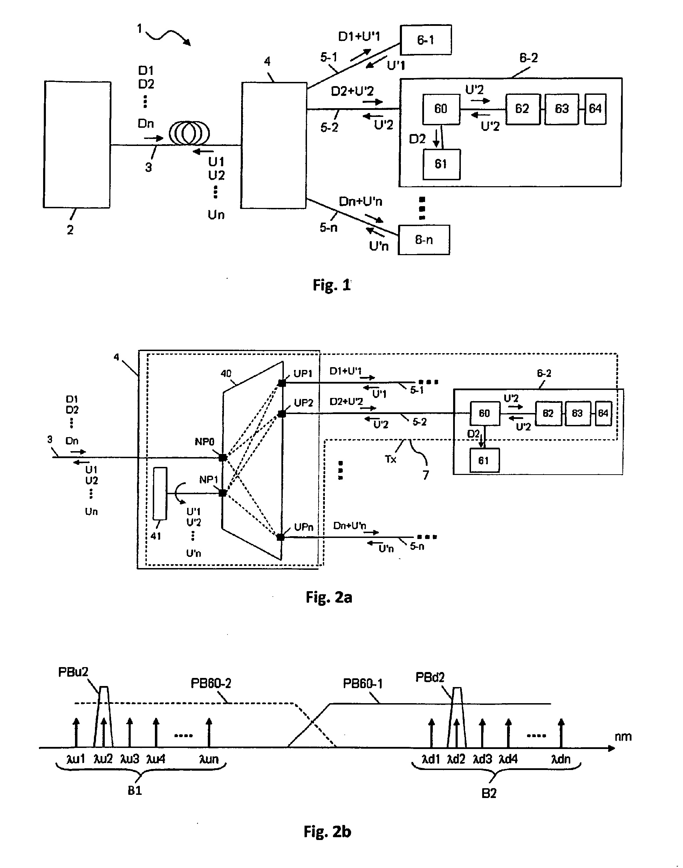

Fig. 1 schematically shows an example WDM PON 1 comprising an OLT 2, a feeder fiber 3, a remote node 4, a number n of distribution fibers 5-1, 5-2, ..., 5-n and a number n of ONUs 6-1, 6-2, ..., 6-n. The number n is an integer equal to or higher than 2, such as for instance 8, 16, 32, etc. The OLT 2 is preferably connected to the remote node 4 by means of the feeder fiber 3. In turn, the remote node 3 is connected to each ONU 6-1, 6-2, ..., 6-n by means of a respective distribution fiber 5-1, 5-2, ..., 5-n.

The feeder fiber 3 may have a length of up to e.g. 40 km. Preferably, each distribution fiber 5-1, 5-2, ..., 5-n has a length comprised between some tens of meters and a few kilometers. The feeder fiber 3 and the distribution fibers 5-1, 5-2, ..., 5-n may be standard single-mode ITU-T G.652-compliant optical fibers. All the ONUs 6-1, 6-2, ..., 6-n preferably have substantially the same structure.

Furthermore, in Fig. 1 the structure of an example ONU 6-2 is shown in detail. The ONU 6-2 preferably comprises a diplexer 60, a receiver 61, a modulator 62, an optical amplifier 63 and a first mirror 64. The diplexer 60 preferably has a first port connected to the distribution fiber 5-2, a second port connected to the receiver 61 and a third port connected to the modulator 62. The receiver 61 may be any known optical receiver, such as for instance a PiN diode or an APD (Avalanche Photo-Diode). The modulator 62 preferably is an amplitude modulator. The optical amplifier 63 may comprise any optical component suitable for amplifying an optical signal propagating therethrough. Preferably, the optical amplifier 63 exhibits a high saturated gain, in particular low input saturation power and high output saturated power.

The modulator 62 and the optical amplifier 63 may be separated components. In this case, the optical amplifier 63 may comprise for instance an erbium-doped fiber amplifier (EDFA), while the modulator 62 may comprise for instance an electro-optical modulator (e.g. a Mach-Zehnder modulator or an electro-absorption modulator) or an acousto-optic modulator. Alternatively, the modulator 62 and the optical amplifier 63 may be integrated in a same component comprising a gain medium suitable for varying its gain according to a driving signal (e.g. an electrical signal), thereby providing at its output an amplitude-modulated optical signal. An exemplary component of this type is a SOA (Semiconductor Optical Amplifier). Furthermore, the ONU 6-2 may further comprise an electronic circuit (not shown in Figure 1) suitable for providing a driving signal to the modulator 62/optical amplifier 63.

The first mirror 64 is preferably suitable for reflecting optical signals in the wavelength range used for communications between the OLT 2 and the ONU 6-2. In particular, the first mirror 64 may be integral with the optical amplifier 63 and/or with the modulator 62, so as to form a single component. By way of example, the modulator 62, the optical amplifier 63 and the first mirror 64 may be implemented in a single component, such as a Reflective SOA (or, briefly, RSOA). The RSOA may be for instance a C-band RSOA.

Preferably, each ONU 6-1, 6-2, ..., 6-n has assigned a respective upstream wavelength $\lambda u1$, $\lambda u2$, ... $\lambda un$ and a respective downstream wavelength $\lambda d1$, $\lambda d2$, ... $\lambda dn$ for communicating with the OLT 2. The upstream wavelengths $\lambda u1$, $\lambda u2$, ... $\lambda un$ and the downstream wavelengths $\lambda d1$, $\lambda d2$, ... $\lambda dn$ are preferably assigned by the service provider providing FTTH, FFTB or FTTC services to users through the WDM PON 1.

As shown in Figure 2b, the upstream wavelengths $\lambda u1$, $\lambda u2$, ... $\lambda un$ may be comprised in a first waveband B1, whereas the downstream wavelengths $\lambda d1$, $\lambda d2$, .... $\lambda dn$ may be comprised in a second waveband B2. The first waveband B1 and the second waveband B2 typically do not overlap. In particular, the first waveband B1 may be in the C band, whereas the second waveband may be in the L band. Adjacent downstream wavelengths $\lambda d1$, $\lambda d2$, .... $\lambda dn$ and adjacent upstream wavelengths $\lambda u1$, $\lambda u2$, .... $\lambda un$ are preferably spaced by a same channel spacing (for instance, about 100GHz).

The diplexer 60 provided in the ONU 6-2 (and also in the other ONUs of the WDM PON 1) may be a 1x2 WDM coupler suitable for receiving optical signals through its first port connected to the feeder fiber 3, forwarding through its second port connected to the receiver 61 the wavelengths comprised in the second waveband B2, and through its third port connected to the modulator 62 the wavelengths comprised in the first bandwidth B1. The transfer functions PB60-1 (continuous line) and PB60-2 (dashed line) between the first and second ports and between the first and third ports of the diplexer 60 according to this first embodiment are schematically shown in Figure 2b.

With reference to Figure 2a, the remote node 4 may comprise a wavelength multiplexer/demultiplexer (mux/demux) 40 and a second mirror 41. The mux/demux 40 preferably comprises an AWG (Arrayed Waveguide Grating) having a first network-side port NP0, a second network-side port NP1 and n user-side ports UP1, UP2, ... UPn. The AWG preferably is an athermal AWG. The mux/demux 40 is preferably a cyclic AWG, i.e. each user-side port UP1, UP2, ... UPn has two distinct passbands at two different wavelengths spaced by an integer multiple of the free spectral range of the AWG. The AWG is preferably designed so that such two different wavelengths correspond to the upstream wavelength $\lambda ui$ (i=1, 2, ...n) and the downstream wavelength $\lambda di$ (i=1, 2, ...n) assigned to a same ONU 6-i (i=1, 2, ...n). By way of example, in Figure 2b the two passbands PBu2 and PBd2 of the user-side port UP2 are shown. Each user-side port UP1, UP2, ... UPn is preferably connected to a respective distribution fiber 5-1, 5-2, ..., 5-n.

The first network-side port NP0 is preferably the port at which an $m^{th}$ diffraction order (m being equal to 0, 1, 2, etc.) of optical signals entering the mux/demux 40 through the user-side ports UP1, UP2, ... UPn and having wavelengths equal to the upstream wavelengths $\lambda u1$, $\lambda u2$, .... $\lambda un$ focuses. Further, the second network-side port NP1 is preferably the port at which an $(m+k)^{th}$ or $(m-k)^{th}$ diffraction order (k being an integer equal to or higher than 1, preferably equal to 1) of optical signals entering the mux/demux 40 through the user-side ports UP1, UP2, ... UPn and having wavelengths equal to the upstream wavelengths $\lambda u1$, $\lambda u2$, .... $\lambda un$ focuses. The first network-side port NP0 is preferably connected to the feeder fiber 3, and the second network-side port NP1 is preferably connected to the second mirror 41.

The second mirror 41 may have a reflectivity substantially constant over the whole wavebands B1 and B2. For instance, the second mirror 41 may comprise a metallic coating. Alternatively, the reflectivity of the second mirror 41 may vary versus wavelength, and is preferably higher in the first waveband B1 (upstream wavelengths) than in the second waveband B2 (downstream wavelengths). This wavelength-dependent behavior may be obtained for instance by means of a thin-film filter incorporated in the second mirror 41. This advantageously allows providing cheaper diplexers at the ONUs 6-1, 6-2, ... 6-n, since their bandwidth requirements may be relaxed.

In view of the above, it may be noticed that in the WDM PON 1 of Fig. 1 n cavities are advantageously formed, one per each ONU 6-1, 6-2, ... 6-n. In particular, by referring for instance only to the ONU 6-2, its associated cavity is delimited at its ends by the first mirror 64 and the second mirror 41, and comprises: the optical amplifier 63, the modulator 62, the diplexer 60, the distribution fiber 5-2 and the mux/demux 40 (in particular, the diffraction path joining the user-side port UP2 and the second network-side port NP1).

The reflectivity of the first mirror 64, the gain of the optical amplifier 63, the reflectivity of the second mirror 41 and the transfer function BP60-2 between the first and third port of the diplexer 60 are selected so that, in the first waveband B1, the cavity has preferably a loop gain higher than 1. To this purpose, the optical amplifier 63 preferably has a spectral bandwidth coincident with the first waveband B 1. This advantageously triggers a positive feedback mechanism in the cavity, induces the cavity to emit a lasing optical radiation in the upstream direction at its output (i.e. at the first network-side port NP0). At the cavity steady state, the emission wavelength of the cavity is selected by the mux/demux 40 and the diplexer 60 (that act as filtering elements of the cavity), and is the upstream wavelength $\lambda u2$. In other words, the cavity acts as an upstream laser transmitter TX at the upstream wavelength $\lambda u2$, whose output is the first network-side port NP0 of the mux/demux 40. This transmitter is implemented as a self-tuning direct modulated laser (STML) 7. Such an STML 7, in particular a STML 7 as described in Figs. 2a and 2b, has been described in the parallel patent application EP10168889.3 which is incorporated by reference. In particular, the disclosure regarding the components of the STML 7 is incorporated by reference.

As outlined above, it has been observed that birefringence of the passive components of the STML 7 can lead to polarization mode dispersion (PMD) and/or polarization dependent loss (PDL) in the laser cavity. Both effects may vary in time during network operation due to changes in temperature and geometrical positioning of the fiber, and due to variations on the physical properties of the components. Such PMD and PDL variations do not impact the STML, if the operation of the Gain and Modulation Unit (GMU), typically comprising the optical amplifier 63 and the modulator 62, is independent on the polarization state of the incoming light. However, if the GMU exhibits a polarization dependent operation, the performance of the STML 7 is typically highly compromised, and the STML might not operate at all.

It has been shown that it is possible to provide un-cooled GMUs having relatively high gain, output power and modulation bandwidth. On the other hand, un-cooled polarization insensitive GMUs have not yet been demonstrated. It is therefore desirable to enable the use of polarization sensitive GMU components, while preserving polarization insensitive operation of the laser cavity, in order to allow the design of high modulation bandwidth, gain and output power STMLs which operating in an un-cooled mode. As a result, cost-effective and colorless ONUs may be provided.

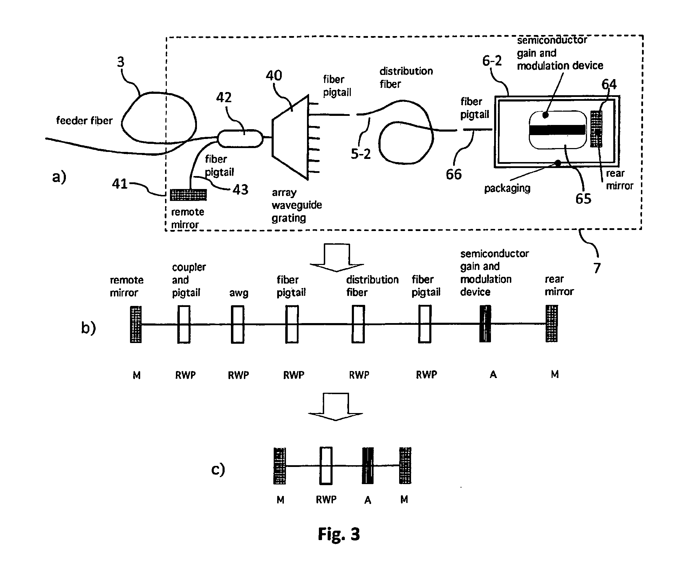

Fig. 3a illustrates a further example diagram of a portion of a WDM PON. In a similar manner to Fig. 2a, a feeder fiber 3, a remote node 4 and an example ONU 6-2 are depicted. The remote node 4 comprises the remote mirror 41 and the AWG 40. Furthermore, the fibre pigtail and coupler 42 for connecting a fiber or waveguide 43 to the remote mirror 41 with the AWG 40 is illustrated. The remote node 4 is linked to the ONU 6-2 via a distribution fiber 5-2. The ONU 6-2 may comprise the components outlined in the context of Fig. 2a. In particular, the ONU 6-2 may comprise a fiber pigtail 66 for connecting with the distribution fiber 5-2. Furthermore, the ONU 6-2 may comprise a Gain and Modulation Unit (GMU) 65 which may be implemented using a semiconductor optical amplifier (SOA). In particular, the GMU 65 may comprise a modulator 62 and an optical amplifier 63 as outlined in the context of Fig. 2a (not shown as separate components in Fig. 3a). In addition, the ONU 6-2 may comprise a rear mirror 64 which may be integrated with the SOA to form a RSOA.

As outlined above, the STML 7 setup described in the context of Figs. 2a and 3a may be used to provide colourless ONUs 6-2. In order to allow for a long-reach and/or high frequency operation, the gain, output power and/or modulation bandwidth of the GMU 65 should be increased. At the same time, the STML 7 is typically impacted by birefringence of the passive components, i.e. the embody device (ED), of the laser cavity, which may significantly impact the performance of the STML 7.

The impact of ED birefringence on an STML 7 including a polarization sensitive GMU 65 may be counteracted by using polarization maintaining fibers (PMF) and components in the laser cavity. In particular, the distribution fiber 5-2 could be implemented as a PMF. However, this solution has the drawback that installed fibers in the access network are typically standard single-mode fibers (SMF) and not PMF. Furthermore, the cost of PMFs is significantly higher than the cost of standard SMFs, thereby increasing the cost for future fiber installations in the access networks.

Alternatively the impact of ED birefringence can be counteracted by using a polarization insensitive GMU 65 in the laser cavity. However, designing a GMU 65 for un-cooled operation with a low polarization dependent gain (PDG) may be difficult to achieve. For the time being, GMU's 65 based on SOA have demonstrated a relatively low PDG (less than 1dB). This relatively low PDG is achieved by using bulk SOA structures which typically require cooled operation in order to ensure a sufficiently high gain and output power for ONU applications. On the other hand, it has been found that un-cooled high power and high modulation bandwidth GMU's 65 may be achieved using semiconductor Multi-Quantum Well (MQW) devices, for example MQW-SOAs. However, such un-cooled high power and high modulation bandwidth GMU's 65 typically exhibit a highly polarization dependent gain (PDG). It should be noted that by removing the constraint of a polarization independent gain, it may be expected that also bulk SOA structures may be designed for un-cooled operation. By removing the requirements to have polarisation insensitive operation for the GMU, more degrees of freedom are available in designing the GMU with high output power, gain, electro-optical bandwidth and to enable un-cooled operation. This applies to both bulk and MQW components.

In view of the above analysis, it is proposed to adapt the STML 7 of Figs. 2a and 3a in order to enable the use of GMU's 65 which exhibit a highly polarization dependent gain. For this purpose, the STML 7 components shown in Figs. 2a and 2b are represented by an "equivalent circuit" depicted in Fig. 3b. In Fig. 3b, each component of the laser cavity is described in terms of "polarization operators" acting on the State Of Polarization of light (SOP) travelling in the laser cavity. Each polarization operator can be mathematically described by a Jones Matrix, a Muller Matrix or movements on the Poincare sphere.

It may be assumed that the rear 64 and remote 41 mirrors can be represented by the "Mirror" operator [M] which is given by the matrix

$$[M] = \begin{bmatrix} -1 & 0 \\ 0 & 1 \end{bmatrix}.$$

The fibers 43, 5-2 - including the pigtails splices and power couplers 42, 66 - may be represented by the "Retarder Wave Plate" [RWP] operator described by its PMD and PDL properties. The GMU 65 properties can be represented by the polarization operator "Analyzer" [A]. In fact, the GMU can be, in general, represented by a dichroic elleptical analyzer (2x2 matrix), characterised by having all terms different from zero. In the particular context, which considers a high PDG SOA, it may be assumed that the two non-diagonal terms are negligible, and that the ratio between the two diagonal terms is similar to those of an ideal "Analyzer" [A]. Given the above assumptions, it can be concluded that the laser cavity - comprising all ED - can be described by a singular [RWP] operator. This is illustrated in Figs. 3b and 3c. It is shown that the remote and rear mirrors may be described by the [M] operator. The remaining passive components of the laser cavity may be described by a plurality of [RWP] operators. This plurality of [RWP] operators may be combined to a singular [RWP] operator as illustrated in Fig. 3c. The GMU 65 may be described by an [A] operator.

Using the above model of the laser cavity, measures for counteracting the variations of the SOP of the light introduced by the singular RWP operator in the laser cavity may be determined. If not compensated, the variations of the SOP could be converted into amplitude variations by the [A] operator, thereby compromising the cavity operation of lasing and modulation. Using the model shown in Fig. 3c, the impact on the SOP of light leaving the GMU 65 towards the remote mirror 41 and back may be described by the operation:

$$\overline{[RWP]} \cdot [M] \cdot \overline{\overline{[RWP]}},$$

wherein the operator $\overline{[...]}$ indicates the polarization operation in the first propagation direction towards the remote or second mirror 41, and wherein the operator $\overline{\overline{[...]}}$ indicates the polarization operation in the retracting second propagation direction towards the rear or first mirror 64. In order to ensure a proper operation of the laser cavity, the SOP of the light in the laser cavity should remain unchanged, i.e. the optical path from and back to the GMU 65, i.e. from and back to the [A] operator, should result in a mirror operation [M].

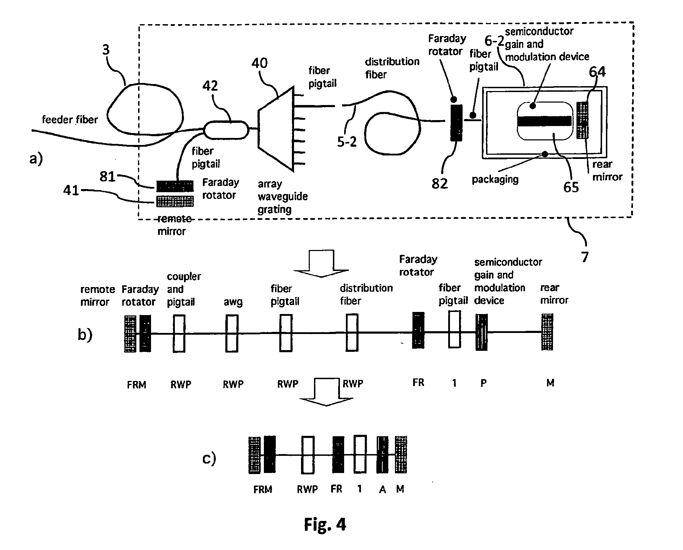

It is proposed in the present document to introduce two passive components known as Faraday rotators (FR) within the cavity of the STML 7. These Faraday rotators act as polarisation operators [FR], as described in Fig. 4. A Faraday rotator is an optical device that rotates the polarization of light due to the Faraday effect, which in turn is based on a magneto-optic effect. The basic principle of a Faraday rotator is that one polarization of the input light is in ferromagnetic resonance with the material of the FR which causes its phase velocity to be higher than the phase velocity of the other polarization of the input light. As a result, the polarization of the light is rotated.

In the setup of Fig. 4a, each FR introduces a polarisation rotation equal to $\pm 45$ degrees or $\pi/4$. In particular, the FR 81 associated with the remote cavity mirror 41 forms a Faraday Rotator Mirror (FRM) which is configured to completely compensate any birefringence (reciprocal) change occurring in a retracing fiber-optic circuit. This means that an FRM is configured to undo the [RWP] operation performed in the retracing cavity from the GMU 65 to the remote mirror 41 and back, i.e.

$$\overline{[RWP]} \cdot [FRM] \cdot \overline{\overline{[RWP]}} = [FRM].$$

In other words, the laser cavity of STML 7 is an example of a retracing fibre-optic circuit for the light beam travelling from and back to the [A] operator (i.e. the GMU 65). Therefore, the FRM ensures that the polarization state of the light beam which retraces its path through the laser cavity of the STML 7 back to the [A] operator is independent of all details of the birefringence of the ED. This may be ensured as long as the round-trip time of the light beam is lower than the speed of the polarisation variations (i.e. variations in birefringence) occurring in the cavity. This condition is typically satisfied for a cavity length of several kilometers, i.e. for STML 7 comprising typical distribution fibres 5-2.

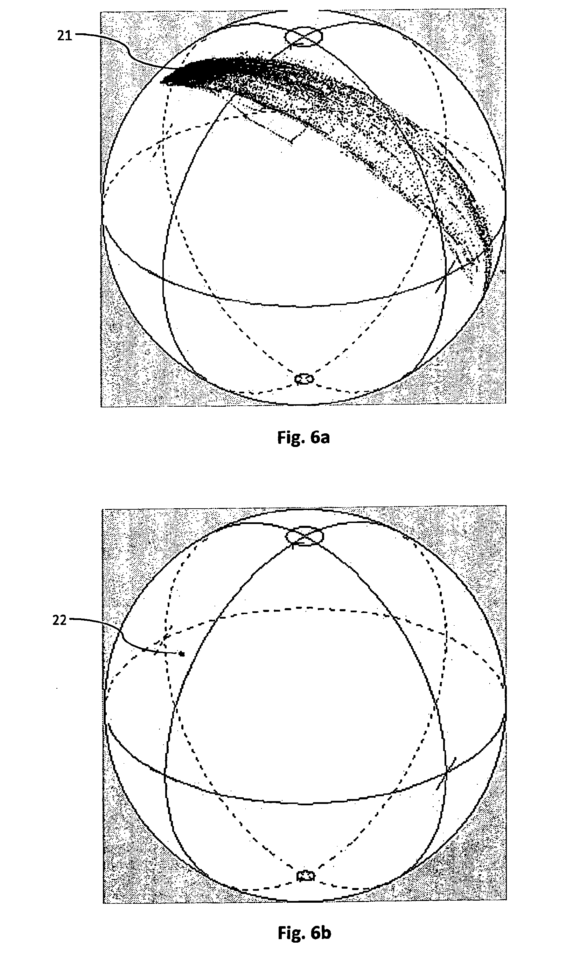

The FR 81 alone does not ensure a unique polarization state of the light at the GMU 65. As a matter of fact, it has been found that the FRM, i.e. the component comprising the functionality of FR 81 and the remote mirror 41 only ensures that the light at the end of the retracing journey, (i.e. the round trip in the STML cavity) is orthogonal to an arbitrary initial state. As such, the SOP of the light entering the GMU 65 still varies as illustrated in Fig. 6a, wherein the SOP 21 of light at the output of the cavity is visualized on the Poincare sphere. It can be seen that the SOP 21 of the light entering the GMU 65 moves from one state to another orthogonal state after the round trip in the STML cavity.

It is therefore proposed to use a further FR 82 at the ONU 6-2 side which ensures that the SOP of light from the distribution fibre 5-2 is always aligned to the principal polarisation plane of the analyser [A]. Thus, the SOA can be engineered to exhibit gain only on one polarisation plane, therefore enabling the use of GMU's 65 having high polarization dependent gain.

The use of FRs 81, 82 is illustrated in Fig. 4a. In particular, the remote FR 81 at the remote mirror 41 is shown, which in combination with the remote mirror 41 provides an [FRM] operator. The polarization operators of a FR may be described as follows:

$$\overline{[FR]} = \begin{bmatrix} \dfrac{\sqrt{2}}{2} & \dfrac{\sqrt{2}}{2} \\ -\dfrac{\sqrt{2}}{2} & \dfrac{\sqrt{2}}{2} \end{bmatrix},$$

$$\overline{\overline{[FR]}} = \begin{bmatrix} \dfrac{\sqrt{2}}{2} & -\dfrac{\sqrt{2}}{2} \\ \dfrac{\sqrt{2}}{2} & \dfrac{\sqrt{2}}{2} \end{bmatrix},$$

wherein the operation of the Faraday rotator mirror is obtained as

$$[FRM] = \overline{[FR]} \cdot [M] \cdot \overline{\overline{[FR]}} = \begin{bmatrix} 0 & -1 \\ -1 & 0 \end{bmatrix}.$$

As a result of using the FR 81 at the remote mirror 41, i.e. as a result of using an FRM, the birefringence of the laser cavity may be compensated. However, the compensation of birefringence within the laser cavity does not necessarily ensure that the polarization state of the light at the GMU 65 corresponds to the preferred polarization of the GMU 65, i.e. the polarization for which the GMU 65 provides optimal gain, modulation bandwidth and/or output power performance. It can be shown that the FRM only ensures birefringence compensation, and that the retracing light from the FRM alternates between two orthogonal polarization states (as illustrated by the SOP diagram 21 of Fig. 6a).

By using the additional FR 82 at the GMU 65, the SOP of the light at the GMU 65 can be fixed to a single polarization state. This can be seen when considering the polarization operators of the optical path from the input of the FR 82 to the remote mirror 41 and back. As outlined above, the laser cavity can be described by the operator of the FRM. When using the additional FR 82, the overall polarization operation becomes:

$$\overline{[FR]}[FRM]\overline{\overline{[FR]}} = \begin{bmatrix} \dfrac{\sqrt{2}}{2} & \dfrac{\sqrt{2}}{2} \\ -\dfrac{\sqrt{2}}{2} & \dfrac{\sqrt{2}}{2} \end{bmatrix} \cdot \begin{bmatrix} 0 & -1 \\ -1 & 0 \end{bmatrix} \cdot \begin{bmatrix} \dfrac{\sqrt{2}}{2} & -\dfrac{\sqrt{2}}{2} \\ \dfrac{\sqrt{2}}{2} & \dfrac{\sqrt{2}}{2} \end{bmatrix} = \begin{bmatrix} -1 & 0 \\ 0 & 1 \end{bmatrix} = [M].$$

This means that the laser cavity comprising the additional FR 82 at the GMU 65 behaves like a mirror, thereby ensuring that the SOP of light travelling within the laser cavity is retraced This has been confirmed experimentally as shown in Fig. 6b. It can be seen that the SOP 22 of the light at the output of the cavity is fixed at a particular state on the Poincare sphere. As a result of this, highly polarization dependent GMU's 65 may be used, i.e. un-cooled GMU's 65 having a high gain, high modulation bandwidth and high optical output power.

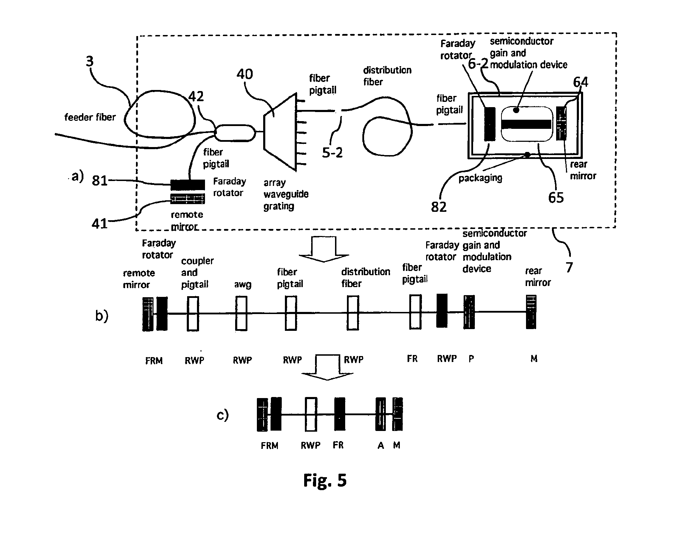

Fig. 4a illustrates an example STML 7 where the FR 82 is attached to the GMU 65 using a fiber. In particular, the additional FR 82 may be inserted in the optical path outside the GMU package on the output fiber pigtail 66. In this case the fiber pigtail 66 should be engineered in order to maintain light SOP (e.g. a polarization maintaining (PM) fibre). It should be noted that a polarizer may be integrated within the GMU package at the GMU output, in order to make sure that only linearly polarised light will travel thought the PM fibre. On the other hand, Fig. 5a illustrates an alternative implementation where the FR 82 is directly integrated at the output of the GMU 65, possibly within the GMU package. As illustrated in Figs. 5b and 5c, this would avoid polarization rotation occurring in the fiber pigtail 66.

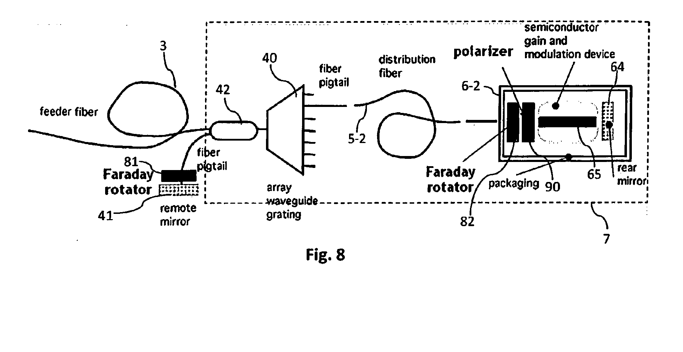

An example STML 7 comprising a polarizer 90 is illustrated in Fig. 8. As outlined above, such a polarizer 90 may be integrated within the GMU package. Typically, the polarizer 90 is positioned upstream of the GMU 65 and downstream of the FR 82. The polarizer or polarization filter 90 may be adapted to isolate light of only a single polarization from the light generated by the GMU 65. As such, the spontaneous emission of light at different polarizations may be suppressed. By using a polarizer 90, it can be ensured that only light of a single polarization enters the cavity, thereby stabilizing the polarization of the laser output radiation. The (single) polarizer 90 and the FR 82 may be integrated in a single optical component.

It should be noted that the use of Faraday rotators 81 and 82 is applicable to various embodiments of STMLs 7. In particular, the STML 7 of Fig. 2a may be adapted by providing an FR 81 adjacent to the remote mirror 41, e.g. in conjunction with the remote mirror 41. As such, an FR 81 may be provided at the port NP1 between the multiplexer / demultiplexer 40 and the remote mirror 41. In particular, the FR 81 may be provided within a joint package comprising the FR81, the multiplexer / demultiplexer 40 and the remote mirror 41. In a similar manner, the FR 82 may be provided within the ONU 6-2 of Fig. 2a. In particular, the FR 82 may be provided between the diplexer 60 and the modulator 62. In particular, the FR 82 may be provided within a joint package comprising the FR82, the modulator 62, the optical amplifier 63 and/or the rear mirror 64.

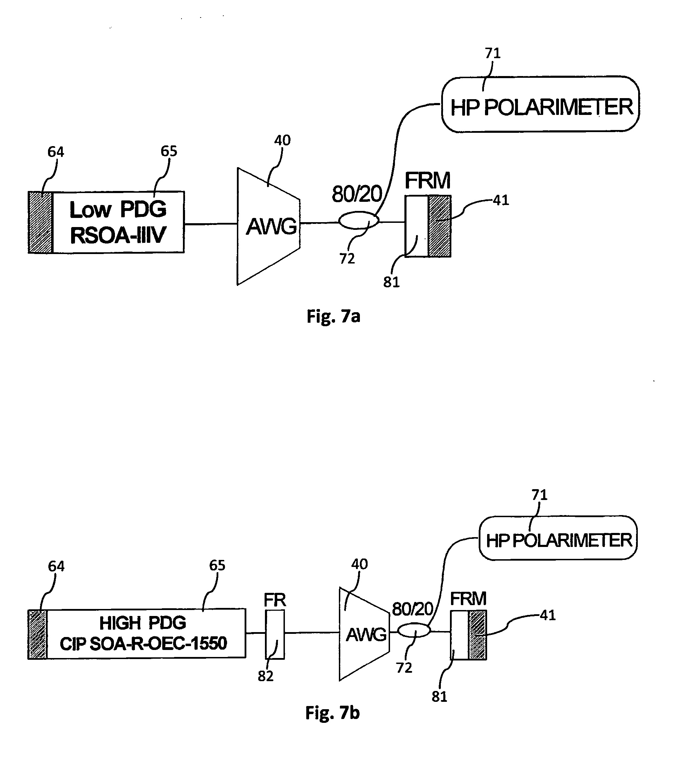

As already indicated above, the performance of the STML 7 has been analyzed experimentally. The experimental setups are depicted in Figs. 7a and 7b. In a first configuration (Fig. 7a) a STML 7 setup comprising only the second FR 81 at the remote mirror 41 is analyzed. In addition to the STML components shown in Figs. 4a and 5a, the experimental setup of Fig. 7a comprises a fiber coupler (80/20 coupler) 72, whose output (e.g. 20% output) is measured by a polarimeter 71. The measured SOP 21 is shown in Fig. 6a on the Poincare sphere. It can be seen that the SOP 21 oscillates between two orthogonal states of polarization. It should be noted that when using only a single FR 81 (i.e. when not using the FR 81 at the GMU 65), a low-PDG RSOA has to be used as a GMU 65, because a high PDG RSOA does not sustain lasing activity in the cavity of the STML 7.

In a second configuration (Fig. 7b) a STML 7 setup comprising the first 82 and second 81 FR is analyzed. In this case, a high PDG R-SOA (e.g. 20 dB PDG) may be used as a GMU 65. The cavity is closed by a Faraday mirror (FRM) comprising FR 81 and mirror 41. Output radiation is extracted by a fiber coupler 72, whose output is measured by a polarimeter 71. The measured SOP 22 is shown in Fig. 6b on the Poincare sphere, as a stable point with small dispersion and with a high degree of polarization.

In the present document a setup for a self-tuning direct modulated laser for WDM PON has been described, which can make use of highly polarization dependent gain and modulation units such as MQW-SOAs. By removing the requirement of polarization insensitive operation, the design of the GMU can be optimized for high output power and gain (i.e. longer reach) and modulation bandwidth (i.e. higher bit rates per ONU). As a result, un-cooled operation is enabled, thereby allowing for a smaller integration factor of the gain and modulation unit as no TEC (thermoelectric cooling) is required. In addition, by ensuring that the laser cavity performs as a mirror, a stable operation of the laser cavity over time can be ensured.

It should be noted that the description and drawings merely illustrate the principles of the proposed methods and systems. It will thus be appreciated that those skilled in the art will be able to devise various arrangements that, although not explicitly described or shown herein, embody the principles of the invention. Furthermore, all examples recited herein are principally intended expressly to be only for pedagogical purposes to aid the reader in understanding the principles of the proposed methods and systems and the concepts contributed by the inventors to furthering the art, and are to be construed as being without limitation to such specifically recited examples and conditions. Moreover, all statements herein reciting principles, aspects, and embodiments of the invention, as well as specific examples thereof, are intended to encompass equivalents thereof. Finally, it should be noted that any block diagrams herein represent conceptual views of illustrative circuitry embodying the principles of the invention.

## Claims

1. An optical transmitter arrangement (7) for a wavelength division multiplexing passive optical network, the arrangement (7) comprising

   - a first mirror (64) and a second mirror (41) at a first end and a second end of a laser cavity, respectively;
   - an optical amplifier (63) configured to amplify light which has a polarization in a first polarization plane; wherein the optical amplifier (63) is positioned within the cavity upstream the first mirror (64);
   - an optical waveguide (5-2) configured to transmit light from the optical amplifier (63) to the second mirror (41) and vice versa;
   - a first non-reciprocal polarization rotator (82) positioned within the cavity upstream of the optical amplifier (63) and downstream of the optical waveguide (5-2); and
   - a second non-reciprocal polarization rotator (81) positioned within the cavity upstream of the optical waveguide (5-2) and downstream of the second mirror (41);

   wherein the first (82) and second (81) non-reciprocal polarization rotators are configured to rotate the polarization of the light such that light which re-enters the optical amplifier (63) after having been reflected by the second mirror (41) has a polarization lying essentially in the first polarization plane.

2. The optical transmitter arrangement (7) of claim 1, wherein

   - the optical waveguide (5-2) affects the polarization of the light;
   - the first (82) and second (81) non-reciprocal polarization rotators are Faraday rotators; and/or
   - the first (82) and second (81) non-reciprocal polarization rotators are configured to rotate the polarization of the light by substantially ±45 degrees at each pass;

3. The optical transmitter arrangement (7) of any previous claim, wherein the first non-reciprocal polarization rotator (82) and the optical amplifier (63) are integrated within a small form factor pluggable unit.

4. The optical transmitter arrangement (7) of any previous claim, further comprising a wavelength selection unit (40, 42) within the cavity upstream of the optical waveguide (5-2) and downstream of the second non-reciprocal polarization rotator (81), wherein the wavelength selection unit (40, 42) is configured to

- filter out light at a first wavelength ($\lambda$u2) from the light coming from the optical amplifier (63); and
- couple a fraction of the filtered light at the first wavelength ($\lambda$u2) to the second mirror (41) through a reflection port (NP1) of the wavelength selection unit (40, 42)

thereby generating an optical radiation at the first wavelength ($\lambda$u2) propagating back and forth in the cavity.

5. The optical transmitter arrangement (7) of claim 4, wherein the wavelength selection unit (40, 42) is further configured to

- direct a further fraction of the filtered light at the first wavelength ($\lambda$u2) to an output port (NP0) of the wavelength selection unit (40, 42), thereby providing an optical signal at the first wavelength ($\lambda$u2) at the output port (NP0)

6. The optical transmitter arrangement (7) of any of claims 4 to 5, wherein the wavelength selection unit (40, 42) comprises an optical multiplexer / demultiplexer (40) and/or an optical power splitter (42).

7. The optical transmitter arrangement (7) of any of claims 4 to 6, wherein the second non-reciprocal polarization rotator (81) and the second mirror (41) or a combined Faraday Rotator Mirror configured to provide the functionality of the second non-reciprocal polarization rotator (81) and the second mirror (41), as well as the wavelength selection unit (40, 42) form a remote unit (4) which is optically connected to the optical amplifier (63) via the optical waveguide (5-2).

8. The optical transmitter arrangement (7) of any of claims 4 to 7, further comprising

- a modulator (62) configured to modulate the optical radiation at the first wavelength ($\lambda$u2); wherein the modulator (62) is positioned within the cavity.

9. The optical transmitter arrangement (7) of claim 8, wherein the optical amplifier (63) and the modulator (62) are implemented using an un-cooled semiconductor optical amplifier.

10. The optical transmitter arrangement (7) of claim 9, wherein the optical amplifier (63) and the modulator (62) are implemented using a Multi-Quantum Well semiconductor optical amplifier.

11. The optical transmitter arrangement (7) of any previous claim, further comprising:

- a polarizer (90) upstream of the optical amplifier (63) and downstream of the first non-reciprocal polarization rotator (82), wherein the polarizer (90) is configured to ensure that only light which has a polarization in the first polarization plane is transmitted from the optical amplifier (63).

12. A wavelength division multiplexing passive optical network (1) comprising:

- an optical network unit (6-2) configured to transmit an optical uplink signal (U2);
- a remote node (2) configured to multiplex the optical uplink signal (U2) onto a feeder fiber (3);
- the feeder fiber (3) connecting the remote node (2) to an optical line termination (2); and
- the optical line termination (2) configured to receive the optical uplink signal (U2);

wherein the optical network unit (6-2) and the remote node (2) comprise an optical transmitter arrangement (7) according to any of claims 1 to 11.

13. The wavelength division multiplexing passive optical network (1) of claim 12, wherein the optical waveguide (5-2) is a distribution fiber connecting the remote node (2) and the optical network unit (6-2).

14. A method for generating an optical signal within a laser cavity comprising a first (64) and second mirror (41), the method comprising:

- generating and amplifying an optical signal having a polarization in a first polarization plane by use of an optical amplifier (63);
- reflecting the optical signal at a rear side of the optical amplifier using the first mirror (64);
- rotating the polarization of the optical signal by an initial rotation at a front side, opposite of the rear side, of the optical amplifier;
- subsequent to rotating, transmitting the optical signal via an optical waveguide (5-2) to the second mirror (41);
- subsequent to transmitting, rotating the polarization of the optical signal by substantially ±45 degrees plus or minus a multiple of substantially 180 degrees, prior to reflection by the second mirror (41);
- reflecting the optical signal at the second mirror (41);
- rotating the polarization of the optical signal by substantially ±45 degrees plus or minus a multiple of substantially 180 degrees subsequent to reflection by the second mirror (41);
- subsequent to rotating, transmitting the optical signal via the optical waveguide (5-2) to the optical amplifier (5-2); and
- rotating the polarization of the optical signal by a final rotation prior to entering the optical amplifier (5-2), wherein the initial and the final rotation are such that the optical signal entering the optical amplifier (5-2) is polarized along the first polarization plane.

**Patentansprüche**

1.  Optische Senderandordnung (7) für ein passives optisches Wellenlängenmultiplex-Netzwerk, wobei die Anordnung (7) umfasst:

    - Einen ersten Spiegel (64) und einen zweiten Spiegel (41) jeweils an einem ersten Ende und einem zweiten Ende eines Laser-Hohlraums;
    - einen optischen Verstärker (63), welcher dafür konfiguriert ist, Licht mit einer Polarisation in einer ersten Polarisationsebene zu verstärken; wobei der optische Verstärker (63) in dem Hohlraum stromaufwärts des ersten Spiegels (64) angeordnet ist;
    - einen optischen Wellenleiter (5-2), welcher dafür konfiguriert ist, Licht von dem optischen Verstärker (63) an den zweiten Spiegel (41) und umgekehrt zu übertragen;
    - einen ersten nichtreziproken Polarisationsdreher (82), welcher in dem Hohlraum stromaufwärts des optischen Verstärkers (63) und stromabwärts des optischen Wellenleiters (5-2) angeordnet ist; und
    - einen zweiten nichtreziproken Polarisationsdreher (81), welcher in dem Hohlraum stromaufwärts des optischen Wellenleiters (5-2) und stromabwärts des zweiten Spiegels (41) angeordnet ist;

    wobei der erste (82) und der zweite (81) nichtreziproke Polarisationsdreher dafür konfiguriert sind, die Polarisation des Lichts derart zu drehen, dass das Licht, welches erneut in den optischen Verstärker (63) eintritt, nachdem es von dem zweiten Spiegel (41) reflektiert wurde, eine im Wesentlichen in der ersten Polarisationsebene liegende Polarisation aufweist.

2.  Optische Senderanordnung (7) nach Anspruch 1, wobei

    - der optische Wellenleiter (5-2) die Polarisation des Lichts beeinflusst;
    - der erste (82) und der zweite (81) nichtreziproke Polarisationsdreher Faraday-Dreher sind; und/oder
    - der erste (82) und der zweite (81) nichtreziproke Polarisationsdreher dafür konfiguriert sind, die Polarisation des Lichts bei jedem Durchlauf um im Wesentlichen ± 45 Grad zu drehen.

3.  Optische Senderanordnung (7) nach einem beliebigen der vorstehenden Ansprüche, wobei der erste nichtreziproke Polarisationsdreher (82) und der optische Verstärker (63) in einer steckbaren Einheit mit geringem Formfaktor integriert sind.

4.  Optische Senderanordnung (7) nach einem beliebigen der vorstehenden Ansprüche, weiterhin umfassend eine Wellenlängenauswahleinheit (40, 42) in dem Hohlraum stromaufwärts des optischen Wellenleiters (5-2) und stromabwärts des zweiten nichtreziproken Polarisationsdrehers (81), wobei die Wellenlängenauswahleinheit (40, 42) konfiguriert ist für

    - das Herausfiltern von Licht mit einer ersten Wellenlänge (λu2) aus dem von dem optischen Verstärker (63) kommenden Licht; und
    - das Koppeln eines Bruchteils des gefilterten Lichts mit einer ersten Wellenlänge (λu2) an den zweiten Spiegel (41) über einen Reflexionsport (NP1) der Wellenlängenauswahleinheit (40, 42),

    wodurch eine optische Strahlung mit der ersten Wellenlänge (λu2) erzeugt wird, welche sich in dem Hohlraum vorwärts und rückwärts verbreitet.

5. Optische Senderanordnung (7) nach Anspruch 4, wobei die Wellenlängenauswahleinheit (40, 42) weiterhin konfiguriert ist für

 - das Leiten eines weiteren Bruchteils des gefilterten Lichts mit einer ersten Wellenlänge ($\lambda$u2) an einen Ausgangsport (NP0) Wellenlängenauswahleinheit (40, 42), wodurch an dem Ausgangsport (NP0) ein optisches Signal mit der ersten Wellenlänge ($\lambda$u2) bereitgestellt wird.

6. Optische Senderanordnung (7) nach einem beliebigen der Ansprüche 4 bis 5, wobei die Wellenlängenauswahleinheit (40, 42) einen optischen Multiplexer/Demultiplexer (40) und/oder einen optischen Leistungsteiler (42) umfasst.

7. Optische Senderanordnung (7) nach einem beliebigen der Ansprüche 4 bis 6, wobei der zweite nichtreziproke Polarisationsdreher (81) und der zweite Spiegel (41) oder ein kombinierter Faraday-Dreher-Spiegel, welcher für die Bereitstellung der Funktionalität des zweiten nichtreziproken Polarisationsdrehers (81) und des zweiten Spiegels (41) konfiguriert ist, sowie die Wellenlängenauswahleinheit (40, 42) eine entfernt angeordnete Einheit (4) bilden, welche über den optischen Wellenleiter (5-2) optisch an den optischen Verstärker (63) angeschlossen ist.

8. Optische Senderanordnung (7) nach einem beliebigen der Ansprüche 4 bis 7, weiterhin umfassend

 - einen Modulator (62), welcher dafür konfiguriert ist, die optische Strahlung mit der ersten Wellenlänge ($\lambda$u2) zu modulieren, wobei der Modulator (62) in dem Hohlraum angeordnet ist.

9. Optische Senderanordnung (7) nach Anspruch 8, wobei der optische Verstärker (63) und der Modulator (62) unter Verwendung eines ungekühlten optischen Halbleiterverstärkers implementiert werden.

10. Optische Senderanordnung (7) nach Anspruch 9, wobei der optische Verstärker (63) und der Modulator (62) unter Verwendung eines optischen Multi-Quantum-Well-Halbleiterverstärkers implementiert werden.

11. Optische Senderanordnung (7) nach einem beliebigen der vorstehenden Ansprüche, weiterhin umfassend:

 - Einen Polarisator (90) stromaufwärts des optischen Verstärkers (63) und stromabwärts des ersten nichtreziproken Polarisationsdrehers (82), wobei der Polarisator (90) dafür konfiguriert ist, zu gewährleisten, dass nur Licht mit einer Polarisation in der ersten Polarisationsebene von dem optischen Verstärker (63) übertragen wird.

12. Passives optisches Wellenlängenmultiplex-Netzwerk (1), umfassend:

 - Eine optische Netzwerkeinheit (6-2), welche dafür konfiguriert ist, ein optisches Uplink-Signal (U2) zu übertragen;
 - einen entfernt angeordneten Knoten (2), welcher dafür konfiguriert ist, das optische Uplink-Signal (U2) auf eine Zuleitungsfaser (3) zu multiplexen;
 - die Zuleitungsfaser (3), welche den entfernt angeordneten Knoten (2) mit dem optischen Leitungsabschluss (2) verbindet; und
 - den optischen Leitungsabschluss (2), welcher für den Empfang des optischen Uplink-Signals (U2) konfiguriert ist;

 wobei die optische Netzwerkeinheit (6-2) und der entfernt angeordnete Knoten (2) eine optische Senderanordnung (7) gemäß einem beliebigen der Ansprüche 1 bis 11 umfassen.

13. Passives optisches Wellenlängenmultiplex-Netzwerk (1) nach Anspruch 12, wobei der optische Wellenleiter (5-2) eine Verteilungsfaser ist, welche den entfernt angeordneten Knoten (2) mit der optischen Netzwerkeinheit (6-2) verbindet.

14. Verfahren zur Erzeugung eines optischen Signals in einem Laser-Hohlraum, welcher einen ersten (64) und einen zweiten (41) Spiegel umfasst, wobei das Verfahren umfasst:

 - Erzeugen und Verstärken eines optischen Signals mit einer Polarisation in einer ersten Polarisationsebene unter Verwendung eines optischen Verstärkers (63);

- Reflektieren des optischen Signals an einer hinteren Seite des optischen Verstärkers unter Verwendung des ersten Spiegels (64);
- Drehen der Polarisation des optischen Signals durch eine anfängliche Drehung an einer Vorderseite, welche der hinteren Seite gegenüber liegt, des optischen Verstärkers;
- im Anschluss an die Drehung, Übertragen des optischen Signals über einen optischen Wellenleiter (5-2) an den zweiten Spiegel (41);
- im Anschluss an die Übertragung, Drehen der Polarisation des optischen Signals um im Wesentlichen ± 45 Grad plus oder minus ein Vielfaches von im Wesentlichen 180 Grad vor der Reflexion am zweiten Spiegel (41);
- Reflektieren des optischen Signals an dem zweiten Spiegel (41);
- Drehen der Polarisation des optischen Signals um im Wesentlichen ± 45 Grad plus oder minus ein Vielfaches von im Wesentlichen 180 Grad im Anschluss an die Reflexion am zweiten Spiegel (41);
- im Anschluss an die Drehung, Übertragen des optischen Signals über den optischen Wellenleiter (5-2) an den optischen Verstärker (63); und
- Drehen der Polarisation des optischen Signals durch eine abschließende Drehung, bevor es in den optischen Verstärker(63) eintritt, wobei die anfängliche und die abschließende Drehung derart erfolgen, dass das in den optischen Verstärker (63) eintretende optische Signal längs der ersten Polarisationsebene polarisiert wird.

**Revendications**

1. Arrangement transmetteur optique (7) pour un réseau optique passif à multiplexage par répartition en longueur d'onde, l'arrangement (7) comprenant

   - un premier miroir (64) et un deuxième miroir (41), respectivement à une première extrémité et une deuxième extrémité d'une cavité laser ;
   - un amplificateur optique (63) configuré pour amplifier la lumière qui présente une polarisation dans un premier plan de polarisation ; l'amplificateur optique (63) étant positionné à l'intérieur de la cavité en amont du premier miroir (64) ;
   - un guide d'onde optique (5-2) configuré pour transmettre la lumière de l'amplificateur optique (63) vers le deuxième miroir (41) et inversement ;
   - un premier rotateur de polarisation non réciproque (82) positionné à l'intérieur de la cavité en amont de l'amplificateur optique (63) et en aval du guide d'onde optique (5-2) ; et
   - un deuxième rotateur de polarisation non réciproque (81) positionné à l'intérieur de la cavité en amont du guide d'onde optique (5-2) et en aval du deuxième miroir (41) ; le premier (82) et le deuxième (81) rotateurs de polarisation non réciproque étant configurés pour produire une rotation de la polarisation de la lumière de telle sorte que la lumière qui entre de nouveau dans l'amplificateur optique (63) après avoir été réfléchie par le deuxième miroir (41) présente une polarisation qui se trouve essentiellement dans le premier plan de polarisation.

2. Arrangement transmetteur optique (7) selon la revendication 1, avec lequel

   - le guide d'onde optique (5-2) affecte la polarisation de la lumière ;
   - le premier (82) et le deuxième (81) rotateurs de polarisation non réciproque sont des rotateurs de Faraday ; et/ou
   - le premier (82) et le deuxième (81) rotateurs de polarisation non réciproque sont configurés pour produire une rotation de la polarisation de la lumière sensiblement de ±45 degrés à chaque passage.

3. Arrangement transmetteur optique (7) selon l'une quelconque des revendications précédentes, avec lequel le premier rotateur de polarisation non réciproque (82) et l'amplificateur optique (63) sont intégrés à l'intérieur d'une unité enfichable à petit facteur de forme.

4. Arrangement transmetteur optique (7) selon l'une quelconque des revendications précédentes, comprenant en plus une unité de sélection de longueur d'onde (40, 42) à l'intérieur de la cavité en amont du guide d'onde optique (5-2) et en aval du deuxième rotateur de polarisation non réciproque (81), l'unité de sélection de longueur d'onde (40, 42) étant configurée pour

   - éliminer par filtrage une première longueur d'onde ($\lambda$u2) de la lumière en provenance de l'amplificateur optique (63) ; et
   - coupler une fraction de la lumière filtrée à la première longueur d'onde ($\lambda$u2) vers le deuxième miroir (41) à travers un port de réflexion (NP1) de l'unité de sélection de longueur d'onde (40, 42)

générant ainsi un rayonnement optique à la première longueur d'onde (λu2) qui se propage en arrière et en avant dans la cavité.

5. Arrangement transmetteur optique (7) selon la revendication 4, avec lequel l'unité de sélection de longueur d'onde (40, 42) est en outre configurée pour

  - diriger une fraction supplémentaire de la lumière filtrée à la première longueur d'onde (λu2) vers un port de sortie (NP0) de l'unité de sélection de longueur d'onde (40, 42), délivrant ainsi un signal optique à la première longueur d'onde (λu2) sur le port de sortie (NP0).

6. Arrangement transmetteur optique (7) selon l'une quelconque des revendications 4 à 5, avec lequel l'unité de sélection de longueur d'onde (40, 42) comprend un multiplexeur/démultiplexeur optique (40) et/ou un séparateur de puissance optique (42).

7. Arrangement transmetteur optique (7) selon l'une quelconque des revendications 4 à 6, avec lequel le deuxième rotateur de polarisation non réciproque (81) et le deuxième miroir (41) ou un miroir de rotateur de Faraday configuré pour réaliser la fonctionnalité du deuxième rotateur de polarisation non réciproque (81) et du deuxième miroir (41), ainsi que l'unité de sélection de longueur d'onde (40, 42) forment une unité déportée (4) qui est connectée optiquement à l'amplificateur optique (63) par le biais du guide d'onde optique (5-2).

8. Arrangement transmetteur optique (7) selon l'une quelconque des revendications 4 à 7, comprenant en outre

  - un modulateur (62) configuré pour moduler le rayonnement optique à la première longueur d'onde (λu2), le modulateur (62) étant positionné à l'intérieur de la cavité.

9. Arrangement transmetteur optique (7) selon la revendication 8, avec lequel l'amplificateur optique (63) et le modulateur (62) sont mis en oeuvre en utilisant un amplificateur optique semiconducteur non refroidi.

10. Arrangement transmetteur optique (7) selon la revendication 9, avec lequel l'amplificateur optique (63) et le modulateur (62) sont mis en oeuvre en utilisant un amplificateur optique semiconducteur à puits quantique multiple.

11. Arrangement transmetteur optique (7) selon l'une quelconque des revendications précédentes, comprenant en outre :

  - un polariseur (90) en amont de l'amplificateur optique (63) et en aval du premier rotateur de polarisation non réciproque (82), le polariseur (90) étant configuré pour garantir que seule la lumière qui présente une polarisation dans le premier plan de polarisation est transmise depuis l'amplificateur optique (63).

12. Réseau optique passif (1) à multiplexage par répartition en longueur d'onde, comprenant :

  - une unité de réseau optique (6-2) configurée pour transmettre un signal de liaison optique montante (U2) ;
  - un noeud déporté (2) configuré pour multiplexer le signal de liaison optique montante (U2) sur une fibre d'alimentation (3) ;
  - la fibre d'alimentation (3) connectant le noeud déporté (2) à une terminaison de ligne optique (2) ; et
  - la terminaison de ligne optique (2) étant configurée pour recevoir le signal de liaison optique montante (U2) ;

  l'unité de réseau optique (6-2) et le noeud déporté (2) comprenant un arrangement transmetteur optique (7) selon l'une quelconque des revendications 1 à 11.

13. Réseau optique passif (1) à multiplexage par répartition en longueur d'onde selon la revendication 12, avec lequel le guide d'onde optique (5-2) est un filtre de distribution qui relie le noeud déporté (2) et l'unité de réseau optique (6-2).

14. Procédé de génération d'un signal optique à l'intérieur d'une cavité laser comprenant un premier (64) et un deuxième (41) miroir, le procédé comprenant :

  - génération et amplification d'un signal optique qui présente une polarisation dans un premier plan de polarisation en utilisant un amplificateur optique (63) ;
  - réflexion du signal optique sur un côté arrière de l'amplificateur optique en utilisant le premier miroir (64) ;

- rotation de la polarisation du signal optique par une rotation initiale au niveau d'un côté avant, opposé au côté arrière, de l'amplificateur optique ;

- après la rotation, transmission du signal optique par le biais d'un guide d'onde optique (5-2) vers le deuxième miroir (41) ;

- après la transmission, rotation de la polarisation du signal optique sensiblement de $\pm 45$ degrés plus ou moins un multiple de sensiblement 180 degrés avant la réflexion par le deuxième miroir (41) ;

- réflexion du signal optique sur le deuxième miroir (41) ;

- rotation de la polarisation du signal optique sensiblement de $\pm 45$ degrés plus ou moins un multiple de sensiblement 180 degrés après la réflexion par le deuxième miroir (41) ;

- après la rotation, transmission du signal optique par le biais du guide d'onde optique (5-2) vers l'amplificateur optique (63) ; et

- rotation de la polarisation du signal optique d'une rotation finale avant la pénétration dans l'amplificateur optique (63), la rotation initiale et la rotation finale étant telles que le signal optique qui pénètre dans l'amplificateur optique (63) est polarisée le long du premier plan de polarisation.

Fig. 1

Fig. 2a

Fig. 2b

**Fig. 3**

**Fig. 4**

**Fig. 5**

**Fig. 6a**

**Fig. 6b**

**Fig. 7a**

**Fig. 7b**

**Fig. 8**

**EP 2 512 043 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2011018054 A
- WO 2009007973 A
- EP 10168889 A